Europäisches Patentamt

European Patent Office

Office européen des brevets

(19)

(11) Veröffentlichungsnummer : **0 141 335**
**B1**

(12)

# EUROPÄISCHE PATENTSCHRIFT

(45) Veröffentlichungstag der Patentschrift :
09.09.87

(51) Int. Cl.⁴ : **G 03 F   1/00**

(21) Anmeldenummer : **84112467.0**

(22) Anmeldetag : **16.10.84**

(54) Verfahren zur Herstellung einer Röntgenmaske mit Metallträgerfolie.

(30) Priorität : 25.10.83 DE 3338717

(43) Veröffentlichungstag der Anmeldung :
15.05.85 Patentblatt 85/20

(45) Bekanntmachung des Hinweises auf die Patenterteilung : 09.09.87 Patentblatt 87/37

(84) Benannte Vertragsstaaten :
AT BE CH DE FR GB LI LU NL

(56) Entgegenhaltungen :
EP-A- 0 069 265
US-A- 4 037 111

(73) Patentinhaber : Siemens Aktiengesellschaft Berlin und München
Wittelsbacherplatz 2
D-8000 München 2 (DE)

(72) Erfinder : Glashauser, Walter
Paul-Klee-Strasse 4
D-8000 München 71 (DE)
Der weitere Erfinder hat auf seine Nennug verzichtet

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 141 335 B1

## Beschreibung

Die Erfindung betrifft ein Verfahren zur Herstellung von Masken für die Röntgenlithografie, bestehend aus einem Rahmen, einer darauf aufgespannten, für Röntgenstrahlen durchlässigen Trägerfolie aus Metall und aus den darauf befindlichen, für Röntgenstrahlen undurchlässigen Maskenstrukturen, die bei der Abbildung das Muster im Röntgenresist erzeugen.

Die Röntgenlithografie ist ein Reproduktionsverfahren, bei dem durch Röntgenstrahlen die Strukturen einer Röntgenmaske durch Schattenprojektion auf einem Substrat abgebildet werden. Eine der Hauptschwierigkeiten für die industrielle Anwendung der Röntgenlithografie liegt in der Herstellung geeigneter Röntgenmasken.

Die Röntgenmaske besteht aus einem Rahmen, einer darauf aufgespannten Metallfolie und aus den darauf befindlichen Absorberstrukturen.

In der DE-C-26 26 851 ist ein Verfahren zur Herstellung von Masken für die Röntgenlithografie beschrieben und dargestellt. Bei diesem Verfahren besteht der Strukturträger aus Metall oder Kunststoff, der zusammen mit der Maskenstruktur auf einer Unterlage, zum Beispiel Glas gebildet wird. Die Unterlage wird durch selektives Ätzen unter Verwendung einer Ätzabdeckung derart abgeätzt, daß lediglich ihr Randbereich verbleibt und den äußeren Maskenrahmen bildet.

Der Erfindung liegt die Aufgabe zugrunde, ein Fertigungsverfahren für Röntgenmasken zu entwickeln, mit dem Masken mit einer Trägerfolie aus Metall einfacher als bisher herzustellen sind. Zudem sollte in einer besonderen Ausführungsform die Trägerfolie transparente Flächen, die mit Absorberstrukturen teilweise überdeckt sind, besitzen, um so eine Justierung zwischen Maske und bereits erfolgten Strukturierungen im Resist zu ermöglichen.

Um die dünne Trägerfolie mechanisch zu verstärken soll auf der Rückseite der Absorberstrukturen diese mit einer weiteren Metallschicht verstärkt werden, so daß die Trägerfolie zwischen den Absorberstrukturen einerseits und den Verstärkungsstrukturen andererseits liegt. Die Verstärkungsstrukturen müssen gegenüber den Absorberstrukturen etwas zurückversetzt liegen, damit diese bei der Röntgenbestrahlung nicht im Strahlengang liegen.

Die Erfindung besteht darin, daß eine metallische Trägerplatte, die nach Fertigstellung der Röntgenmaske den Rahmen ergibt, mit einer weiteren Metallschicht überzogen wird, auf der durch Aufdampfen oder Aufsputtern eine 1-3 µm dicke Trägerfolie aus Metall abgeschieden wird, auf die eine 10 bis 15 µm dicke Polymethylmetacrylatschicht aufgebracht wird, die in bekannter Weise strukturiert wird, woran anschließend die freigelegten Partien galvanisch mit Nickel 1 bis 2 µm dick und Gold 8-10 µm dick aufgefüllt werden und schließlich in die Trägerplatte durch einen Ätzvorgang bis zu der ersten Metallschicht ein Fenster eingeätzt wird und durch einen weiteren Ätzvorgang die in dem Fenster freiliegende Metallschicht strukturiert wird.

Der Vorteil der Erfindung besteht darin, daß mit diesem Verfahren hohe Absorberstrukturen mit kleinsten Abmessungen erzeugt werden können. Diese Absorberstrukturen können von der Rückseite mechanisch durch eine weitere Metallschicht unterstützt werden, so daß sich eine sehr stabile Anordnung ergibt, obwohl die Trägerfolie sehr dünn sein kann.

Weitere Einzelheiten der Erfindung ergeben sich aus den Unteransprüchen.

Die Erzeugung tiefer Resiststrukturen, wie sie für die Herstellung von Präzisionsflachteilen mit Hilfe der Röntgenlithografie benötigt werden, erfordert eine Röntgenmaske mit einem hohen Maskenkontrast.

Der Kontrast einer Maske wird durch die Wahl des Trägerfolien- und Absorbermaterials und dessen Dicken bei vorgegebener Wellenlängenverteilung der Röntgenstrahlung bestimmt.

Einen für die Herstellung von Präzisisonsflachteilen ausreichenden Maskenkontrast ergibt die Metallkombination Gold als Absorber und Titan als Träger wobei die Goldstrukturen eine Minimaldicke von 8 µm aufweisen müssen und die Titanfolie maximal 3 µm dick sein darf.

Die Erfindung wird anhand der Figuren erläutert.

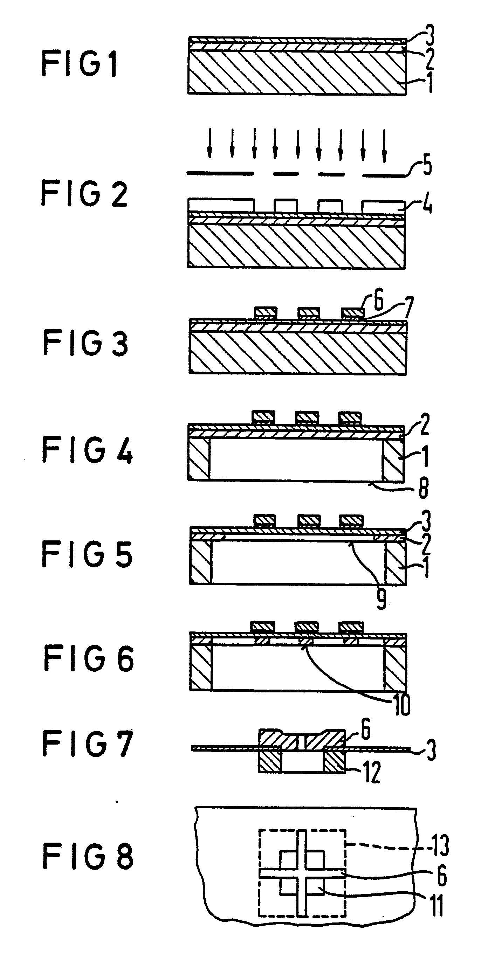

Eine Trägerplatte 1 aus Kupfer, die nach Fertigstellung der Röntgenmaske den Rahmen ergibt, wird mit einer Nickelschicht 2 von mehreren Mikrometern Dicke galvanisch überzogen. Auf diese Nickelschicht folgt durch Aufdampfen oder Aufsputtern zum Beispiel eine 1-3 µm dicke Titanschicht 3, die später die Trägerfolie ergibt (Figur 1).

Die Art der Strukturübertragung bei der Maskenerzeugung — UV- oder Röntgenlithografie — wird durch die Auflösungsgrenze des jeweiligen Verfahrens festgelegt. Prinzipiell sind beide Verfahren anwendbar. Für die Herstellung einer Röntgenmaske gewünschter Absorberabmessungen ist die Röntgenlithografie als Strukturierverfahren notwendig.

Auf die Titanschicht wird, nachdem eine 1 µm dicke PMMA-Lackschicht aufgeschleudert wurde, eine im Kalandrierverfahren erzeugte PMMA-Folie 4 mit einer Dicke von ca. 10-15 µm mit zum Beispiel Cyanacrylatkleber aufgeklebt. Es erfolgt die Strukturierung der PMMA-Schicht mit einer Röntgenmaske 5 in bekannter Weise (Figur 2).

Nach der Strukturierung folgt das Galvanisieren der Absorber mit Gold 6. Hierbei hat sich gezeigt, daß es zweckmäßig ist, vor der Goldgalvanik eine dünne Schicht Nickel 7 (1 µm) galvanisch abzuscheiden, da die Haftfestigkeit zwischen PMMA und Titan für die Goldgalvanik in der Regel nicht ausreicht. Die leichte Unterplattierung des Nickels kann später durch selektives Ätzen entfernt werden.

Die PMMA-Schicht wird mit einem geeigneten Lösemittel entfernt (Figur 3).

Mit einer Ätze, die Kupfer auflöst und in der Nickel resistent ist, wird ein Fenster 8 gewünschter Größe in die Rückseite des Kupferträgers 1 eingeätzt. Dieser Vorgang kann in einer Sprühätzmaschine üblicher Bauart erfolgen. Die ca. 5 μm dicke Nickelschicht wirkt als mechanischer Träger für die darüberliegende empfindliche Titanschicht und als Sperrschicht bei der Ätzung (Figur 4).

Anschließend wird mit einer selektiv arbeitenden Ätzflüssigkeit, zum Beispiel Kupferchlorid, die Nickelschicht 2 fensterartig 9 im Tauchverfahren vorsichtig abgeätzt, oder nach erfolgter Strukturierung mit Fotolack partiell durch Ätzen 10 freigelegt, wobei die Titanfolie 3 nicht angegriffen wird (Figur 5). Die Spannung in der Titanfolie führt dazu, daß die Folie auf dem verbliebenen Rahmen im gespannten Zustand verbleibt.

In einer weiteren Ausführung können nach der Titanbeschichtung (Figur 1) und vor dem Aufkleben der PMMA-Folie in die Titanschicht Fenster 11 eingeätzt werden, die nach erfolgter Strukturierung mit Gold und durchgeführter Fensterätzung von der Rückseite als transparente Justiermarken dienen. Die Titanfenster 11 werden dabei von den Goldstrukturen 6 (Justiermarken) freitragend überspannt.

Zusätzlich können die Justiermarken von der Unterseite mit Nickelstrukturen 12 verstärkt oder versteift werden (Figur 7).

Die Figur 7 zeigt einen Schnitt durch eine Justiermarke und die Figur 8 die Draufsicht auf die Figur 7. Mit 13 ist die gestrichelte Außenkontur des Nickelrahmens 12 angedeutet.

## Patentansprüche

1. Verfahren zur Herstellung von Masken für die Röntgenlithografie bestehend aus einem Rahmen, einer darauf aufgespannten, für Röntgenstrahlen durchlässigen Trägerfolie aus Metall und aus den darauf befindlichen, für Röntgenstrahlen undurchlässigen Maskenstrukturen, die bei der Abbildung das Muster im Röntgenresist erzeugen, dadurch gekennzeichnet, daß eine metallische Trägerplatte (1), die nach Fertigstellung der Röntgenmaske den Rahmen ergibt, mit einer ersten Metallschicht (2) überzogen wird, auf der durch Aufdampfen oder Aufsputtern eine 1-3 μm dicke Trägerfolie (3) aus Metall abgeschieden wird, auf die eine 10-15 μm dicke Polymethylmethacrylatschicht (4) aufgebracht wird, die in bekannter Weise strukturiert wird, woran anschließend die freigelegten Partien galvanisch mit Nickel (7) 1-2 μm dick und darüber mit Gold (6) 8-10 μm dick aufgefüllt werden und schließlich in die Trägerplatte (1) durch einen Ätzvorgang bis zu der ersten Metallschicht (2) ein Fenster (10) eingeätzt wird und durch einen weiteren Ätzvorgang die in dem Fenster freiliegende Metallschicht (10) strukturiert wird.

2. Verfahren nach Anspruch 1, dadurch gekennzeichnet, daß die Trägerplatte (1) aus Kupfer, die Trennschicht (2) zwischen Kupfer und Titan aus Nickel und die Trägerfolie (3) aus Titan besteht.

3. Verfahren nach Anspruch 1, dadurch gekennzeichnet, daß mit einer Ätze, die Kupfer auflöst und in der Nickel resistent ist, ein Fenster (8) gewünschter Größe in die Rückseite des Kupferträgers (1) eingeätzt und anschließend mit einer entsprechend der verwendeten Trägerfolie selektiv arbeitenden Ätzflüssigkeit, zum Beispiel bei Titan als Trägerfolie Kupferchlorid, die Nickelschicht (2) fensterartig im Tauchverfahren abgeätzt wird.

4. Verfahren nach Anspruch 3, dadurch gekennzeichnet, daß die Nickelschicht vor der Ätzung strukturiert wird.

5. Verfahren nach Anspruch 1, dadurch gekennzeichnet, daß in die Trägerfolie (3) mit einer geeigneten Ätze Fenster (11) eingeätzt werden, die nach erfolgter Strukturierung mit Gold und durchgeführter Fensterätzung von der Rückseite als transparente Justiermarken dienen.

6. Verfahren nach Anspruch 5, dadurch gekennzeichnet, daß die Justiermarken und/oder die Goldstrukturen von der Unterseit mit Nickelstrukturen (10) verstärkt oder versteift werden.

7. Verfahren nach Anspruch 1, dadurch gekennzeichnet, daß die Trägerfolie aus Aluminium besteht.

8. Verfahren nach Anspruch 1, dadurch gekennzeichnet, daß die Trägerfolie (3) aus verschiedenen einzelnen, miteinander verbundenen Metallschichten, zum Beispiel Titan, Aluminium, Titan, besteht.

## Claims

1. A process for the production of masks for X-ray lithography consisting of a frame, a metal carrier foil which is stretched over the frame, and is permeable to X-rays, and mask structures arranged on the carrier foil and impermeable to X-rays and which with the image formation produce the pattern in an X-ray resist, characterised in that a metal carrier plate (1), which after the completion of the X-ray mask, forms the frame, is coated with a first metal layer (2) on which a 1-3 μm thick carrier foil (3) consisting of metal is deposited by vapour deposition or sputtering, to which is applied a 10-15 μm thick polymethylmethacrylate layer (4), which is structured in known manner, whereupon the exposed parts are filled by electroplating with nickel (7) in a thickness of 1-2 μm and above the nickel with gold (6) in a thickness of 8-10 μm, and finally, in an etching step a window (10) is etched into the carrier plate (1) down to the first metal layer (2), and in a further etching process the metal layer (10) exposed in the window is structured.

2. A process as claimed in Claim 1, characterised in that the carrier plate (1) consists of copper, the separating layer (2) between the copper and titanium consists of nickel, and the carrier foil (3) consists of titanium.

3. A process as claimed in Claim 1, characterised in that using an etching agent which dissolves copper and to which nickel is resistant, a window (8) of the desired size is etched into the rear of the copper carrier (1) and then, using an etching liquid which operates selectively in accordance with the carrier foil used, for example, when the carrier foil consists of titanium, copper chloride, the nickel layer (2) is etched away to form a window in an immersion process.

4. A process as claimed in Claim 3, characterised in that the nickel layer is structured prior to etching.

5. A process as claimed in Claim 1, characterised in that using a suitable etching agent, windows (11) are etched into the carrier foil (3) and, after the structuring with gold and the window etching from the rear, serve as transparent adjustment marks.

6. A process as claimed in Claim 5, characterised in that the adjustment marks and/or the gold structures are reinforced or stiffened from beneath with nickel structures (10).

7. A process as claimed in Claim 1, characterised in that the carrier foil consists of aluminium.

8. A process as claimed in Claim 1, characterised in that the carrier foil (3) consists of different individual metal layers, for example, titanium, aluminium, titanium, which are connected to one another.

**Revendications**

1. Procédé pour fabriquer des masques utilisés pour la lithographie aux rayons X et constitués par un cadre, par une feuille de support métallique tendue sur ce cadre et transparente pour les rayons X, et par des structures de masques situées sur la feuille de support et opaques aux rayons X et qui produisent, lors de la formation de l'image, le modèle dans la résine sensible aux rayons X, caractérisé par le fait qu'on recouvre la plaque de support métallique (1), qui forme le cadre après la réalisation du masque pour rayons X, avec une première couche métallique (2), sur laquelle on dépose par évaporation ou pulvérisation une couche de support métallique (3) possédant une épaisseur de 1-3 μm, sur laquelle on dépose une couche de polyméthylméthacrylate (4) d'une épaisseur de 10-15 μm, que l'on structure de façon connue, à la suite de quoi on remplit galvaniquement les parties mises à nu dans cette couche avec du nickel (7) sur une épaisseur de 1-2 μm et, sur le nickel, avec de l'or (6) sur une épaisseur de 8-10 μm et enfin on aménage une fenêtre (11) dans la plaque de support (1) au moyen d'un processus de corrosion effectué sur la première couche métallique (2) et on structure la couche métallique (10) qui est à nu dans la fenêtre au moyen d'un autre processus de corrosion.

2. Procédé suivant la revendication 1, caractérisé par le fait que la plaque de support (1) est constituée par du cuivre, que la couche de séparation (2) entre le cuivre et le titane est constituée par du nickel et que la feuille de support (3) est constituée par du titane.

3. Procédé suivant la revendication 1, caractérisé par le fait qu'on aménage une fenêtre (8) de grandeur désirée dans la face arrière du support en cuivre (1), en utilisant un agent corrosif qui dissout le cuivre et à laquelle le nickel résiste, et qu'on réalise une corrosion de la couche de nickel (2) en formant des fenêtres selon le procédé par immersion, en utilisant un liquide corrosif agissant de façon sélective conformément à la feuille de support utilisée, par exemple du chlorure de cuivre dans le cas où l'on utilise du titane en tant que feuille de support.

4. Procédé suivant la revendication 3, caractérisé par le fait qu'on structure la couche de nickel avant d'exécuter la corrosion.

5. Procédé suivant la revendication 1, caractérisé par le fait qu'on aménage dans la feuille de support (3), au moyen d'un agent corrosif approprié, des fenêtres (11) qui servent de marques d'ajustement transparentes après avoir réalisé la structure avec de l'or et l'aménagement des fenêtres par corrosion à partir de la face arrière.

6. Procédé suivant la revendication 5, caractérisé par le fait qu'on renforce ou on rigidifie les marques d'ajustement et/ou les structures en or à partir de la face inférieure, au moyen de structures de nickel (10).

7. Procédé suivant la revendication 1, caractérisé par le fait que la feuille de support est constituée par de l'aluminium.

8. Procédé suivant la revendication 1, caractérisé par le fait que la feuille de support (3) est constituée par différentes couches métalliques individuelles reliées entre elles, par exemple en titane, aluminium, titane.

0 141 335

FIG1

FIG 2

FIG 3

FIG 4

FIG 5

FIG 6

FIG 7

FIG 8